# EUROPEAN PATENT APPLICATION

(11) **EP 4 773 174 A1**
(43) Date of publication of application: **08.07.2026**
(21) Application number: 25305004.1
(22) Date of filing: 02.01.2025
(51) Int. Cl.: H01L 21/66

(54) **ELECTRONIC PRODUCT, RELATED SEMICONDUCTOR PRODUCT, AND METHOD FOR TESTING THE INTEGRITY OF SUCH ELECTRONIC PRODUCT**

(71) Applicant: Murata Manufacturing Co., Ltd., Nagaokakyo-shi, Kyoto 617-8555 (JP)
(72) Inventor: JACQUELINE, Sébastien, 14000 CAEN (FR); BOUSBIA, Hind, 14000 CAEN (FR); LE DUIGOU, Marion, 14000 CAEN (FR); FANTOU, Paul, 14000 CAEN (FR)
(74) Representative: Cabinet Beau de Loménie

(57) **Abstract**

The invention concerns a wafer comprising:
- a metal layer deposited on a substrate, said metal layer comprising at least:
• a first region made of said metal; and
• a porous region comprising a plurality of substantially straight pores that extend from a top surface of the first porous region towards the substrate, the porous region being thicker than the first region;

- at least one integrated device formed inside the pores of the porous region;

the wafer further comprising:
- a test arrangement comprising:
• an insulating layer deposited on both the first region and the porous region,
• a first contact pad and a second contact pad deposited on the insulating layer above the porous region; and

a third contact pad deposited on the insulating layer above the first region.

## Description

### Field of the Invention

The present invention relates to the field of integration and, more particularly, to electronic products, related semiconductor products, and methods for testing the integrity of such electronic products.

The present invention more precisely relates to the testing of electronic components comprising at least one porous region in which, for example, capacitors are arranged.

### Technical Background

The integrity measurements of semiconductor components, carried out notably using cantilever probes, represent a cutting-edge technique used to evaluate the physical and electrical properties of these components at the nanometric scale. A cantilever probe allows for precise probing of the surface of semiconductor components. This method, among other things, enables the detection of defects, the measurement of surface roughness, the mapping of local conductivity variations, and more.

This technique proves particularly useful in quality control and the optimization of the reliability of electronic components, ensuring their proper functioning in increasingly demanding environments.

The impact of measurements performed using cantilever probes on the material being tested is generally limited but depends on the sensitivity of the material and the measurement conditions. Indeed, when a cantilever probe comes into contact with the surface of a semiconductor component, it exerts a mechanical force that, although weak, can, under certain circumstances, damage the material constituting the semiconductor component.

This phenomenon, called scrubbing, refers to the repeated mechanical friction of the probe tip on the surface of the material during measurements. This phenomenon, often compared to an abrasive cleaning action, can lead to nanometric-scale alterations, especially when the probe makes multiple passes or remains in prolonged contact with a specific area of the material.

This friction can cause the progressive removal of material, leading to micro-scratches or local deformations such as topographical changes like scratches or cracks, compromising the functional integrity of the semiconductor component. For instance, in semiconductor components, damage caused by scrubbing can affect local electrical properties, thus altering conductivity or causing operational defects.

Although measurements using cantilever probes are generally considered non-destructive, scrubbing represents a risk for semiconductor components.

As this solution proves to be unsatisfactory, there is a need for solutions enabling to run integrity tests on semiconductor components which do not present such drawbacks.

### Summary of the Invention

To this end, the invention provides a wafer comprising:
- a metal layer deposited on substrate, said metal layer comprising at least:
   - a first region made of said metal; and
   - a porous region comprising a plurality of substantially straight pores that extend from a top surface of the first porous region towards the substrate, the porous region being thicker than the first region;
- at least one integrated device formed inside the pores of the porous region;
the integrated device further comprising:
- a test arrangement comprising:
   - an insulating layer deposited on both the first region and the porous region,
   - a first contact pad and a second contact pad deposited on the insulating layer above the porous region; and
   - a third contact pad deposited on the insulating layer above the first region.

As a corollary, the invention concerns a method for testing a wafer according to the invention, implemented by a measuring device comprising at least three probes, the method comprising:
- simultaneously establishing an electrical contact between a first probe and the first contact pad, a second probe and the second contact pad and a third probe and the third contact pad; and
- measuring, by means of the first probe and the second probe, an electrical parameter indicative of the integrity of the insulating layer between the first contact pad and the second contact pad,
- when the insulating layer between the first contact pad and the second contact pad is sound, measuring, by means of the third probe, an electrical parameter indicative of the integrity of the third contact pad.

The difference in thickness between the porous region and the first region creates a step which is cleverly used when the testing method is implemented.

More specifically, thanks to this step, the probes of the measuring device will first come in contact with the contact pads located above the porous region. Thus, even if the pressure applied by the first probe and the second probe respectively on the first contact pad and the second contact pad is high enough to damage the insulating layer, the chances that the third probe will damage the third contact pad are low.

When the measuring device detects that the insulating layer is sound, e.g. when it is not damaged by the first probe and the second probe, it measures an electrical parameter indicative of the integrity of the third contact pad. This measurement can then be considered to determine the quality and the reliability of the wafer since the integrated devices formed inside the pores were not damaged by the probes of the measuring device.

On the contrary, when the measuring device detects that the insulating layer is damaged, the measurement of the electrical parameter indicative of the integrity of the third contact pad cannot be considered to determine the quality and the reliability of the wafer since the integrated devices formed within the pores of the porous region, may have been damaged by the probes of the measuring device.

The thickness of the metal layer is on the order of a few tens of microns, and the difference in thickness between the first region and the porous region is on the order of a few microns. This difference in thickness is enough to protect the third contact pad in case the probes are applied on the wafer with too much pressure.

Thus, the present solution helps to guard against the effects of scrubbing on the integrated devices while using cantilever probes when running integrity tests on the wafer.

In particular implementations of the method for testing a wafer, the testing method further comprises, when the insulating layer between the first contact pad and the second contact pad is not sound:
- adjust the pressure to be applied by the first probe and the second probe respectively on a fourth contact pad and on a fifth contact pad both deposited on the insulating layer above the porous region;
- simultaneously establishing an electrical contact between the first probe and the fourth contact pad, the second probe and the fifth contact pad and the third probe and a sixth contact pad deposited on the insulating layer above the first region; and
- measuring, by means of the first probe and the second probe, the electrical parameter indicative of the integrity of the insulating layer between the fourth contact pad and the fifth contact pad.

In order to discriminate between a failure caused on the integrated devices by the measurement and a manufacturing defect of the wafer, another round of measurement is performed when the measuring device detects that the insulating layer is damaged.

This other round of measurement is performed on another set of contact pads comprising two contact pads deposited on the insulating layer above the porous region and another contact pad deposited on the insulating layer above the first region, after the pressure to be applied by the probes is adjusted.

For example, when three measurements in a raw indicate that the insulating layer between the two contact pads deposited on the insulating layer above the porous region is damaged, then it is considered that the wafer must be discarded as it suffers from a manufacturing defect.

Of course, any other number of measurements in a raw indicating that the insulating layer between the two contact pads deposited on the insulating layer above the porous region is damaged can be considered to determine whether or not the wafer must be discarded.

In particular implementations of the method for testing a wafer, the electrical parameter indicative of the integrity of the insulating layer is the electrical continuity.

Indeed, when the insulating layer is damaged, either as a consequence of the measurement or as consequence of a manufacturing defect, an electrical current flows between the two contact pads deposited on the insulating layer above the porous region.

As such the detecting this electrical current flow is a simple and effective way to detect damage caused to the wafer.

In particular implementations of the wafer, the metal layer is an anodizable metal layer.

In particular implementations of the wafer, the porous region is obtained by anodizing said anodizable metal.

Anodizing an anodizable metal is a convenient way of obtaining a porous region in which integrated devices can be formed.

In particular implementation of the wafer, said metal has a hardness index lower than or equal to 3 on the Mohs scale.

Metals having a hardness index lower than or equal to 4 on the Mohs scale are more sensitive to scrubbing.

For example, said metal belongs to a group comprising:
- zinc;
- aluminum.

In particular implementations of the wafer, the insulating layer is a passivation layer.

In particular implementations of the wafer, the integrated device is a stacked capacitive structure comprising a bottom electrode layer, a top electrode layer, and a dielectric layer arranged between the bottom and the top electrode layer, so as to form at least one capacitor.

In particular implementations of the wafer, the integrated device comprises a plurality of test arrangements.

### Brief Description of the Drawings

Further features and advantages of the present invention will become apparent from the following description of certain embodiments thereof, given by way of illustration only, not limitation, with reference to the accompanying drawings in which:
- Figure 1, is a side view of a wafer according to an embodiment of the invention,
- Figure 2 is a top view of the wafer according to an embodiment of the invention,
- Figure 3 represents the steps of a method for testing the integrity of the wafer according to an embodiment of the invention,
- Figures 4A to 4C represent the simultaneous positioning of the probes on the contact pads according to an embodiment of the invention.

### Detailed Description of Example Embodiments

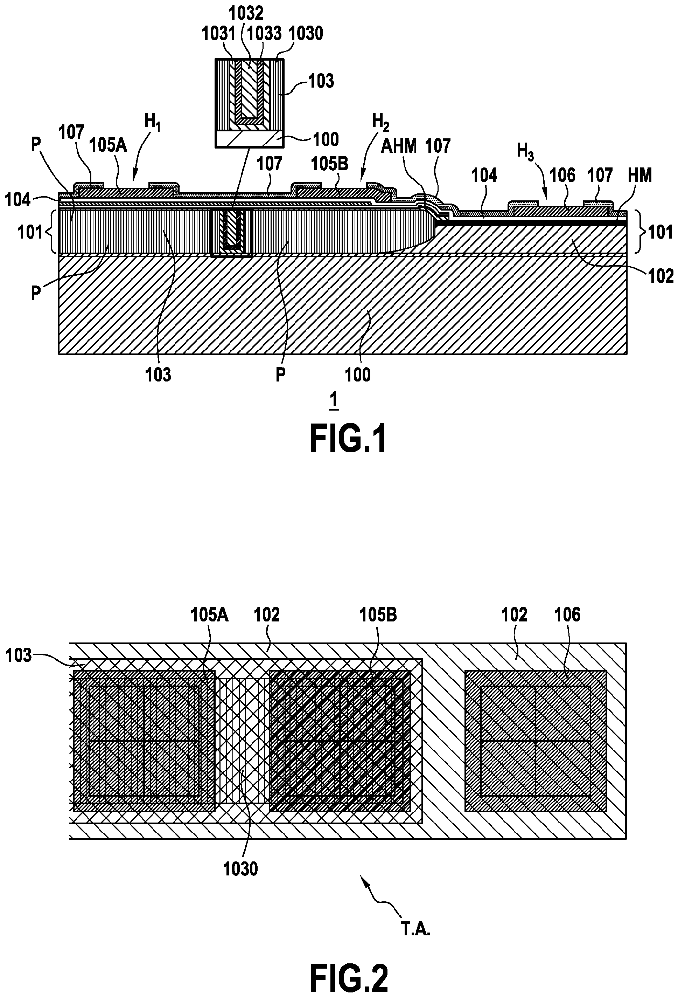

**Figure 1** is a side view of a wafer 1 according to an embodiment of the invention.

The wafer 1 comprises a substrate 100. The substrate 100 may, for example, be a layer of silicon, doped or not, or a layer of dielectric material such as glass.

A metal layer 101 is deposited on the substrate 100. Such a metal layer 101 can comprise aluminum, or zinc. Of course, it is to be noted that other metals may be used.

The solution applies particularly, but not exclusively, to metals exhibiting a hardness index lower than or equal to 4 on the Mohs scale, since these metals are prone to damage during measurements carried out using a cantilever probe.

The metal layer 101 is made of at least two regions, a first region 102 made of the metal of the metal layer 101 and a second region 103 which is a porous region comprising a plurality of substantially straight pores that extend from a top surface of the porous region 103 towards the substrate 100.

In an implementation of the solution, the metal layer 101 is made of an anodizable metal, such as aluminum.

In this case, the porous region 103 is then formed in the metal layer 101 by selectively anodizing certain regions of the metal layer 101. The porous region 103 is then an anodic porous oxide region.

In the following sections of the present document, only the implementation where a single porous region 103 is formed in the metal layer 101 will be described. However, everything described applies as well to the implementation where a plurality of porous regions are formed in the metal layer 101.

As already discussed, in a particular implementation of the solution the porous region 103 is formed by anodization of the metal layer 101, this anodization being performed until pores P formed during the anodization reach the substrate 100. When the pores P reach the substrate 100, the anodization process is stopped since the material constituting the substate 100 is not anodizable.

As explained above, a selective anodization can be carried out in the metal layer 101. In order to selectively anodize the metal layer 101, an anodization mask AHM is placed on the surface of the metal layer 101. The anodization mask can be implemented using the method disclosed in document WO 2019/202046 (possibly with another suitable material for the anodization mask). Such an anodization mask comprises openings defining the region 103 of the metal layer 101 to be anodized.

In particular implementations, the anodization mask is disposable and can be removed after the completion of the anodization process. Such a disposable anodization mask can be a photosensitive resin layer deposited by spin coating on the metal layer 101. In order to remove the anodization mask, a solvent is applied to the surface of the metal layer 101.

In other particular implementations, the anodization mask AHM is a hard mask made, for example of silicon oxide, deposited on the metal layer 101.

As shown on figure 1, the porous region 103 is thicker than the first region 102. This is due to the fact that an anodized metal is an oxide and as such occupies a greater volume. This difference in thickness is advantageously used in the testing method according to the invention.

In order to form at least one integrated device 1030, such as a capacitor or an inductance, etc., in the porous region 103 a hard mask HM is deposited on top of the metal layer 101.

This hard mask HM enables the selection, in the porous region 103 of groups of pores P intended to accommodate the integrated devices. To this end, the hard mask HM comprises an opening located on the porous region 103. The surface of the openings of the hard mask HM can be lower than or equal to the surface of the porous region 103. The hard mask HM can be analogous to the one of document EP 3567645.

In order to form, for example, a capacitor, a stacked capacitive structure 1030 is deposited in the pores P of the porous region 103 accessible through the opening of the hard mask HM.

The bottom of a single pore P in which the capacitive structures are deposited is zoomed-in in the top left corner of figure 1.

The stacked capacitive structure 1030 includes a bottom electrode layer 1031, a top electrode layer 1032, and a dielectric layer 1033 arranged between the bottom electrode layer 1031 and the top electrode layer 1032, to form the capacitor.

An insulating layer 104 is deposited on top of both the first region 102 and the porous region 103. This insulting layer 104 protects the integrated devices as well as the first region 102 from corrosion. As such, in an implementation of the solution, this insulating layer is a passivation layer.

On the one hand, a pair of contact pads 105A and 105B are deposited on the insulating layer 104 above the porous region 103. More particularly, the contact pads 105A and 105B are located above the integrated devices. It is to be noted that more than two contact pads can be deposited on the insulating layer above the porous region 103.

On the other hand, a single contact pad 106 is deposited on the insulating layer 104 above the first region 101. It is to be noted that more than one contact pad can be deposited on the insulating layer above the first region 101.

The contact pads 105A, 105B and 106 are made of metal such as aluminum or copper for example. Of course, any other metal or metal alloy is suitable.

A second insulating layer 107 is deposited on the wafer 1. This insulating layer 107 comprises at least three holes H1-H3 respectively located above the contact pads 105A, 105B and 106. These holes H1-H3 allow a probe to contact with the contact pads during a measurement according to the testing method of the present solution.

**Figure 2** is a top view of the wafer 1. Figure 2 shows more particularly the contact pad 105A and the contact pad 105B deposited above the integrated device 1030. This integrated device 1030 is surrounded by the porous region 103. The porous region, on its part, is surrounded by the first region 101 which is made, for example, of unanodized metal. Next to the contact pad 105B and located above the metal region 102 is the contact pad 106. For the sake of explanation, the insulating layer 104 is omitted on figure 2.

This ensemble of three contact pads 105A, 105B, 106 deposited above the insulating layer 104 above the integrated device 1030 for contact pads 105A and 105B, and above the metal region 102 for contact pad 106 constitutes a test arrangement TA.

In other implementations of the solution, the wafer 1 comprises a plurality of test arrangements TA, each test arrangement TA enabling a measurement.

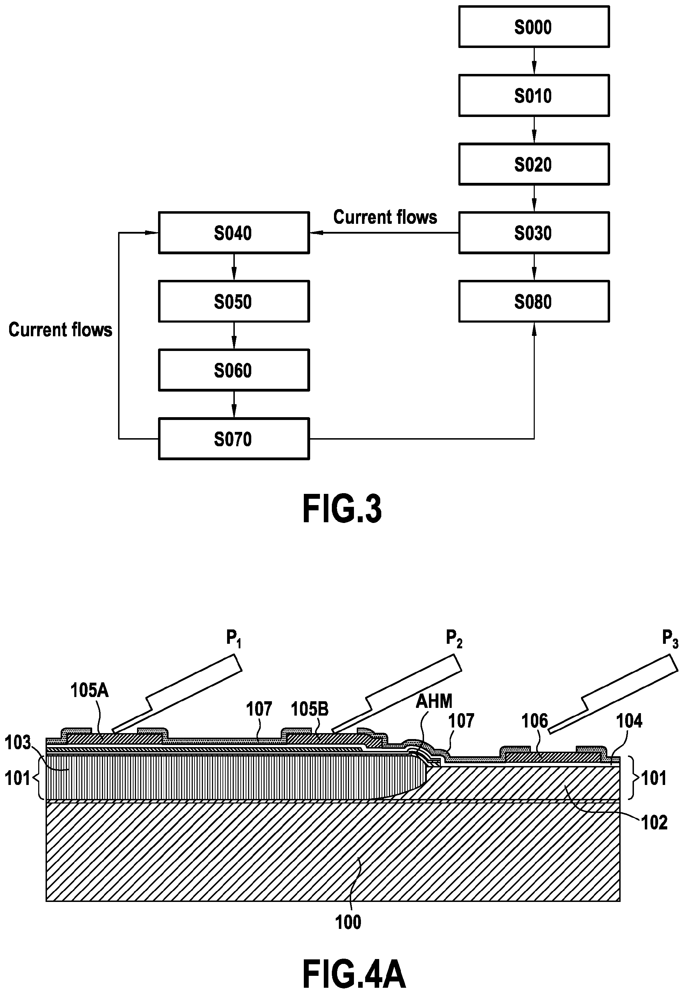

**Figure 3** represents the steps of a method for testing the integrity of the wafer 1 according to an embodiment of the invention.

This testing method is run by a measuring device (not represented on the drawings) comprising as many probes as there are contacts pads in a test arrangement TA. These probes are for example, cantilever probes. In the following description, the measuring device comprises three probes P1 to P3. These probes are actuated together as one.

The measuring device starts a first round of measuring on the wafer 1 (S000).

In order to proceed to the measurement, the probes P1-P3 are simultaneously positioned on the contact pads 105A, 105B and 106 (S010), this is called the touchdown.

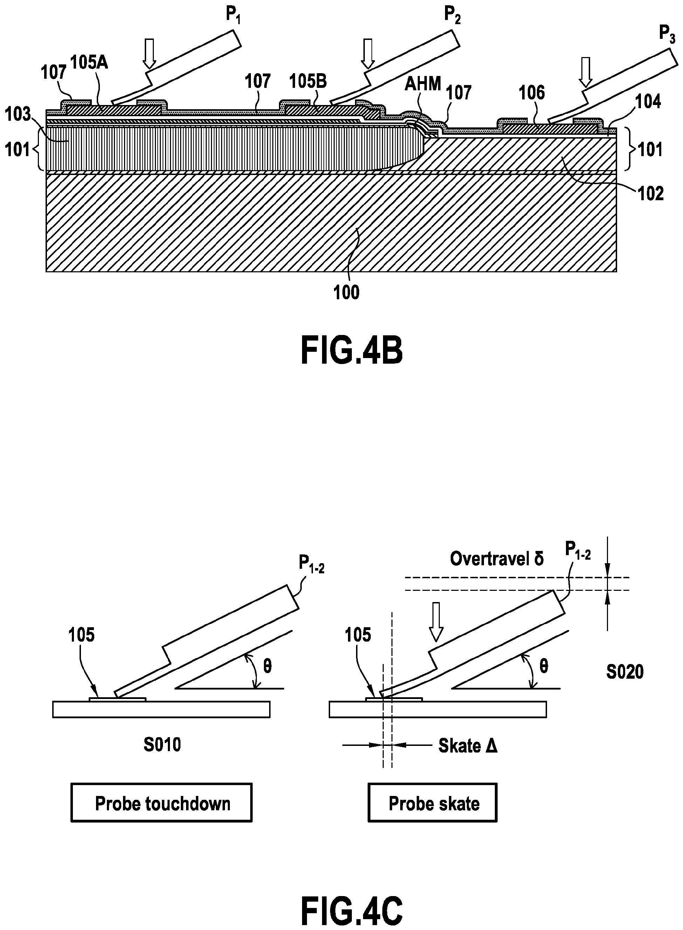

As shown on **figure 4A** and **figure 4C****,** during the touchdown, probe P1 is in contact with contact pad 105A and probe 2 is in contact with contact pad 105B. Due to the difference in thickness between the porous region 103 and the metal region 102, probe P3 hovers over, i.e. is not in contact with, contact pad 106. During touchdown, the probes P1-P3 are tilted of an angle *θ*. This angle *θ* is measured between the surface of the wafer 1 and the probe and is lower than 90°.

Once the probes P1-P3 are properly located over, and in contact with, the contact pads 105A, 105B and 106, the pressure of the probes on the contact pads is adjusted (S020), this adjustment, called overtravel *δ*, as shown on **figure 4C****,** ensures that a proper electrical contact is established between a probe and a contact pad. This overtravel triggers a skate Δ, of the probe on the surface of the contact pad which results, when the pressure exerted by the probe on the surface of the contact pad is too high, in scrubbing and/or in damaging the contact pads and/or the wafer 1.

As shown on **figure 4B****,** during the overtravel, probe P3 is in contact with contact pad 106. Due to the difference in thickness between the porous region 103 and the metal region 102, probe P3 is not subject to overtravel *δ*. A proper electrical contact between probe P3 and contact pad 106 is however ensured.

Once probes P1-P3 are in position, i.e. once they are all in contact with their respective contact pads 105a, 105B, 106, the measuring device measures (S030) by means of probe P1 and probe P2, an electrical parameter indicative of the integrity of the insulating layer between 104 contact pad 105A and contact pad 105B. The measured electrical parameter is for example the electrical continuity.

Thus, if the measuring device detects that an electrical current flows between probe P1, probe P2, contact pad 105A and contact pad 105B, then that means that either the insulating layer 104 is damaged or the wafer 1 suffers a manufacturing defect.

In this case, the measurement (S080) of the electrical parameter indicative of the integrity of the contact pad 106 cannot be considered to determine the quality and the reliability of the wafer 1.

In order to determine whether the insulating layer 104 is damaged or the wafer 1 suffers a manufacturing defect, a second round of measurement is executed.

In order to proceed to another measurement, the probes P1-P3 are simultaneously positioned on the contact pads 105A', 105B' and 106' (S040) of another test arrangement.

During the touchdown, probe P1 is in contact with contact pad 105A' and probe 2 is in contact with contact pad 105B' (S050).

Once the probes P1-P3 are properly located over, and in contact with, the contact pads 105A', 105B' and 106', the pressure of the probes on the contact pads is adjusted (S060) assuming that the pressure applied during the previous round of measurement was too high.

Once probes P1-P3 are in position, the measuring device measures (S070) by means of probe P1 and probe P2, an electrical parameter indicative of the integrity of the insulating layer between 104 contact pad 105A' and contact pad 105B'.

If the measuring device detects that an electrical current flows between probe P1, probe P2, contact pad 105A' and contact pad 105'B, another round of measurement (S040 to S070) is executed.

The number of rounds of measurements to be executed in a raw as long as an electrical current flow is detected between probe P1, probe P2, contact pad 105A' and contact pad 105B' is set by the manufacturer testing their wafers.

When the measuring device fails to detect that an electrical current flows between probe P1, probe P2, contact pad 105A and contact pad 105B, then that means that the insulating layer 104 is sound.

In this case, the measurement (S080) of the electrical parameter indicative of the integrity of the contact pad 106 can be considered to determine the quality and the reliability of the wafer 1. Depending on the result of this measurement of the electrical parameter indicative of the integrity of the contact pad 106 the wafer 1 is deemed to be compliant with the required quality or not.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. A wafer comprising:
- a metal layer deposited on a substrate, said metal layer comprising at least:
• a first region made of said metal; and
• a porous region comprising a plurality of substantially straight pores that extend from a top surface of the first porous region towards the substrate, the porous region being thicker than the first region;
- at least one integrated device formed inside the pores of the porous region;
the wafer further comprising:
- a test arrangement comprising:
• an insulating layer deposited on both the first region and the porous region,
• a first contact pad and a second contact pad deposited on the insulating layer above the porous region; and
• a third contact pad deposited on the insulating layer above the first region.

2. The wafer according to claim 1, wherein the metal layer is an anodizable metal layer.

3. The wafer according to claim 2, wherein the porous region is obtained by anodizing said anodizable metal.

4. The wafer according to any of claims 1 to 3, wherein said metal has a hardness index lower than or equal to 4 on the Mohs scale.

5. The wafer according to any of claims 1 to 4, wherein said metal belongs to a group comprising:
- aluminum; and
- zinc.

6. The wafer according to any of claims 1 to 5, wherein the insulating layer is a passivation layer.

7. The wafer according to any of claims 1 to 6, wherein the integrated device is a stacked capacitive structure comprising a bottom electrode layer, a top electrode layer, and a dielectric layer arranged between the bottom and the top electrode layer, so as to form at least one capacitor.

8. The wafer according to any of claims 1 to 7 comprising a plurality of test arrangements.

9. A method for testing a wafer according to any of claims 1-8, implemented by a measuring device comprising at least three probes, the method comprising:
- simultaneously establishing an electrical contact between a first probe and the first contact pad, a second probe and the second contact pad and a third probe and the third contact pad; and
- measuring, by means of the first probe and the second probe, an electrical parameter indicative of the integrity of the insulating layer between the first contact pad and the second contact pad,
- when the insulating layer between the first contact pad and the second contact pad is sound, measuring, by means of the third probe, an electrical parameter indicative of the integrity of the third contact pad.

10. The testing method according to claim 9 further comprising, when the insulating layer between the first contact pad and the second contact pad is not sound:
- adjust the pressure to be applied by the first probe and the second probe respectively on a fourth contact pad and on a fifth contact pad both pad both deposited on the insulating layer above the porous region;
- simultaneously establishing an electrical contact between the first probe and the fourth contact pad, the second probe and the fifth contact pad and the third probe and a sixth contact pad deposited on the insulating layer above the first region; and
- measuring, by means of the first probe and the second probe, the electrical parameter indicative of the integrity of the insulating layer between the fourth contact pad and the fifth contact pad.

11. The method according to any of claims 9 to 10, wherein the electrical parameter indicative of the integrity of the insulating layer is the electrical continuity.
